# EUROPÄISCHE PATENTSCHRIFT

(11) **EP 3 631 854 B1**
(45) Veröffentlichungstag und Bekanntmachung des Hinweises auf die Patenterteilung: **03.03.2021**
(21) Anmeldenummer: 18719805.6
(22) Anmeldetag: 17.04.2018
(51) Int. Cl.: H01L 23/24, H05K 1/14, H01L 21/98, H01L 25/065, H05K 1/02, H05K 3/28, H05K 3/46

(54) **VERFAHREN ZUM HERSTELLEN EINES LEITERPLATTENSANDWICHS**
METHOD FOR PRODUCING A PRINTED CIRCUIT BOARD SANDWICH
PROCÉDÉ DE FABRICATION D'UN SANDWICH DE CARTES DE CIRCUIT IMPRIMÉES

(30) Priorität: 23.05.2017 DE 102017208772
(43) Veröffentlichungstag der Anmeldung: 08.04.2020
(73) Patentinhaber: Robert Bosch GmbH, 70442 Stuttgart (DE)
(72) Erfinder: MUELLER, Ulrich, 70839 Gerlingen (DE); GERHAEUSSER, Martin, 74336 Brackenheim-Stockheim (DE)
(86) Internationale Anmeldenummer: PCT/EP2018/059756
(87) Internationale Veröffentlichungsnummer: WO 2018/215139

(56) Entgegenhaltungen:
- CN-A- 105 633 050
- DE-A1-102010 042 168
- JP-A- 2012 146 837
- US-A1- 2016 043 811

## Beschreibung

### Gebiet der Erfindung

Die Erfindung betrifft ein Verfahren zum Herstellen eines Leiterplattensandwichs.

### Stand der Technik

Bauteile auf einer Leiterplatte können durch eine Vergussmasse vor schädigenden Einflüssen, wie beispielsweise einem Getriebefluid, insbesondere Getriebeöl geschützt werden. Die Vergussmasse fließt unter Schwerkrafteinfluss. Daher kann die Vergussmasse nur auf einer nach oben ausgerichteten Seite der Leiterplatte aufgebracht werden.

Aus der DE 10 2010 042 168 A1 ist ein Verfahren bekannt, bei dem zwei mit Bauteilen versehene Schaltungsträger unter Zwischenlage von Federelementen so gestapelt werden, dass sich die Bauteile gegenüberliegen. Der gebildete Stapel wird anschließend in ein Moldwerkzeug eingesetzt und mit Moldmasse umschlossen. Weitere Anordnungen mit gestapelten Bauelementen sind aus der CN 105 633 050 A, der US 2016/043811 A1 und der JP 2012 146837 A bekannt.

### Offenbarung der Erfindung

Vor diesem Hintergrund wird mit dem hier vorgestellten Ansatz ein Verfahren zum Herstellen eines Leiterplattensandwichs gemäß dem unabhängigen Anspruch 1 vorgestellt.

Vorteilhafte Weiterbildungen und Verbesserungen des hier vorgestellten Ansatzes sind in den abhängigen Ansprüchen beschrieben.

### Vorteile der Erfindung

Ausführungsformen der vorliegenden Erfindung können in vorteilhafter Weise ermöglichen, Bauteile mit einer hohen Packungsdichte und einem geringen Harzbedarf zu vergießen. Insbesondere kann der Raumbedarf für eine Schaltung ohne Abstriche beim Schutz halbiert werden.

Es wird ein Verfahren zum Herstellen eines Leiterplattensandwichs vorgestellt, wobei das Verfahren dadurch gekennzeichnet ist, dass es die in der nachfolgend angegebenen Reihenfolge durchgeführten Schritte aufweist:
Fertigen eines ersten Leiterplattenteilbereichs und eines zweiten Leiterplattenteilbereichs, wobei der erste Leiterplattenteilbereich und der zweite Leiterplattenteilbereich je einseitig mit Bauteilen versehen werden;
Vergießen der Bauteile in dem ersten Leiterplattenteilbereich mit einer Vergussmasse;
Wenden des zweiten Leiterplattenteilbereichs, sodass die Bauteile in dem zweiten Leiterplattenteilbereich den Bauteilen im ersten Leiterplattenteilbereich gegenüberliegend angeordnet sind;
Stapeln des zweiten Leiterplattenteilbereichs auf den ersten Leiterplattenteilbereich, sodass die Bauteile im zweiten Leiterplattenteilbereich in die Vergussmasse eintauchen; und
Aushärten der Vergussmasse, um den ersten Leiterplattenteilbereich und den zweiten Leiterplattenteilbereich zu dem Leiterplattensandwich zu verbinden.

Ideen zu Ausführungsformen der vorliegenden Erfindung können unter anderem als auf den nachfolgend beschriebenen Gedanken und Erkenntnissen beruhend angesehen werden.

Als Leiterplattensandwich kann ein schichtweiser Aufbau aus Leiterplatten, Bauteilen und Vergussmasse verstanden werden. Dabei sind die Leiterplatten außenliegend angeordnet, währen die Bauteile und die Vergussmasse zwischen den Leiterplatten angeordnet sind. Die Bauteile im ersten und zweiten Leiterplattenteilbereich können zu einer Schaltung verschaltet sein. Ebenso können auf einem oder beiden Leiterplattenteilbereichen unterschiedliche Schaltungen angeordnet sein. Dabei können die Schaltungen zum Platzsparen gemeinsam gefertigt werden. Die Bauteile können in den Leiterplattenteilbereichen angeordnet werden und beispielsweise durch Löten mit Leiterbahnen der Leiterplatten elektrisch leitend verbunden werden. Die Vergussmasse kann durch eine Dosiereinrichtung bereitgestellt werden. Die Vergussmasse kann beispielsweise ein Zweikomponentenkunstharz sein. Beim Aushärten der Vergussmasse können sich Bestandteile der Vergussmasse miteinander vernetzen. Das Aushärten der Vergussmasse kann durch ein Temperieren beschleunigt werden. Der erste Leiterplattenteilbereich und der zweite Leiterplattenteilbereich können auf unterschiedlichen Leiterplatten gefertigt werden. Die Leiterplatten können beispielsweise über Kabel, Flachkabel und/oder Flexfolien elektrisch miteinander verbunden sein. Das Leiterplattensandwich kann über Kabel, Flachkabel, Flexfolien und/oder Steckkontakte elektrisch kontaktiert werden. Die Vergussmasse kann beispielsweise in eine Vertiefung gegossen werden. Die Vertiefung kann beispielsweise durch ein Werkzeug bereitgestellt werden. Weiterhin kann die Vertiefung für die Vergussmasse in Form einer dispensten hoch pastösen Raupe hergestellt werden. Diese Raupe wird anschließend in einem Aushärteprozess gemeinsam mit dem Verguss ausgehärtet.

Die Bauteile im zweiten Leiterplattenteilbereich können so weit in die Vergussmasse eingetaucht werden, bis die Vergussmasse den zweiten Leiterplattenteilbereich benetzt. Dabei können die Bauteile vollständig umschlossen werden, um einen guten Schutz vor Umwelteinflüssen zu erreichen. Lufteinschlüsse können durch Entlüftungsbohrungen und/oder das Stapeln im Vakuum vermieden werden.

Der erste Leiterplattenteilbereich und der zweite Leiterplattenteilbereich können unter Verwendung zumindest einer Stapelhilfe zueinander ausgerichtet werden. Eine Stapelhilfe kann einen Abstand und/oder eine Lage der Leiterplattenteilabschnitte zueinander definieren. Beispielsweise kann der Abstand und/oder die Lage über Zentrierbohrungen und Dorne, Anlageflächen Aufnahmebohrungen und/oder Langlöcher festgelegt werden. Der Abstand und/oder die Lage kann ebenso über Stufendorne, Auflageflächen und/oder Klammern eingestellt werden. Die Stapelhilfen können in einem Werkzeug zum Stapeln angeordnet sein und können nach dem Aushärten der Vergussmasse entfernt werden.

Die zumindest eine Stapelhilfe kann im ersten Leiterplattenteilbereich und/oder im zweiten Leiterplattenteilbereich angeordnet werden. Die Stapelhilfe kann während des Fertigens der Leiterplattenteilbereiche auf der jeweiligen Leiterplatte angeordnet werden. Dann kann die Stapelhilfe nach dem Aushärten der Vergussmasse zwischen den Leiterplatten verbleiben. Beispielsweise können Auflageelemente und/oder Anschlagelemente für den zweiten Leiterplattenteilbereich im ersten Leiterplattenteilbereich angeordnet werden. Auflageelemente und/oder Anschlagelemente für den ersten Leiterplattenteilbereich können im zweiten Leiterplattenteilbereich angeordnet werden. Auflageelemente und/oder Anschlagelemente können auch teilweise im ersten Leiterplattenteilbereich und teilweise im zweiten Leiterplattenteilbereich angeordnet werden.

Der erste Leiterplattenteilbereich kann mit einem ersten Teil eines elektrischen Kontaktelements gefertigt werden. Der zweite Leiterplattenteilbereich kann mit einem zweiten Teil des Kontaktelements gefertigt werden. Der erste Teil und der zweite Teil können unter Verwendung des Kontaktelements beim Stapeln elektrisch leitend miteinander verbunden werden. Der erste Leiterplattenteilbereich und der zweite Leiterplattenteilbereich können unter Verwendung des ersten Teils und des zweiten Teils zueinander ausgerichtet werden. Die Teile des Kontaktelements können als Stecker mit einem in eine Aussparung passenden Stecker ausgeführt sein. Das Kontaktelement kann mehrere Einzelkontakte aufweisen. Das Kontaktelement kann auch einen Abstand zwischen den Leiterplattenteilbereichen festlegen.

Die Bauteile im ersten Leiterplattenteilbereich können so angeordnet werden, dass sie beim Stapeln auf Lücke zu den Bauteilen im zweiten Leiterplattenteilbereich angeordnet sind. Die Bauteile im zweiten Leiterplattenteilbereich können so angeordnet werden, dass sie beim Stapeln auf Lücke zu den Bauteilen im ersten Leiterplattenteilbereich angeordnet sind. Durch ein Anordnen auf Lücke kann ein Abstand zwischen den Leiterplattenteilbereichen minimiert werden. Somit kann ein Verbrauch an Vergussmasse reduziert werden, da ein freies Volumen zwischen den Leiterplatten auf ein Minimum reduziert werden kann. Das freie Volumen wird dann durch eine Höhe des höchsten Bauteils im ersten Leiterplattenteilbereich oder im zweiten Leiterplattenteilbereich bestimmt. Das Aushärten der Vergussmasse kann beschleunigt werden, da eine geringere Menge Vergussmasse schneller temperiert werden kann.

Die Bauteile im ersten Leiterplattenteilbereich und die Bauteile im zweiten Leiterplattenteilbereich können auf einer durchgehenden Leiterplatte angeordnet werden. Zwischen dem ersten Leiterplattenteilbereich und dem zweiten Leiterplattenteilbereich kann ein Biegebereich angeordnet sein, der im Schritt des Wendens gebogen wird. Der Biegebereich kann ausgedünnt sein und wie ein Scharnier wirken. Der Biegebereich kann auch nach dem Fertigen beispielsweise durch Materialabtrag ausgedünnt werden. In dem Biegebereich können Leiterbahnen innerhalb der Leiterplatte verlaufen, um den ersten Leiterplattenteilbereich elektrisch mit dem zweiten Leiterplattenteilbereich zu verbinden. Die Leiterplattenteilbereiche können auch auf einer durchgehenden Folienleiterplatte gefertigt werden. Der Biegebereich kann von Bauteilen frei bleiben und im Schritt des Wendens gebogen werden. Die ausgehärtete Vergussmasse kann eine Steifigkeit des Leiterplattensandwichs bereitstellen.

Um den ersten Leiterplattenteilbereich kann mit einem Dammmaterial ein umlaufender Dammbereich aufgebaut werden. Ein Raum innerhalb des Dammbereichs kann mit der Vergussmasse zumindest teilweise aufgefüllt werden. Ein Dammmaterial kann auf dem gleichen Harz basieren, wie die Vergussmasse. Das Dammmaterial kann geleeartig sein, um einen dreidimensionalen Dammbereich auszubilden. Der Dammbereich kann eine Werkzeugkavität zum Einfüllen der Vergussmasse ersetzen. Das Dammmaterial kann auf den ersten Leiterplattenteilbereich aufgedruckt werden. Der Dammbereich kann höher aufgebaut werden, als die Vergussmasse in den Raum eingefüllt wird. Die Vergussmasse kann durch das Eintauchen der Bauteile im zweiten Leiterplattenteilbereich bis auf die Höhe des Dammbereichs ansteigen. So kann Vergussmasse eingespart werden und ein Auslaufen der Vergussmasse beim Stapeln verhindert werden.

Es wird darauf hingewiesen, dass einige der möglichen Merkmale und Vorteile der Erfindung hierin mit Bezug auf unterschiedliche Ausführungsformen beschrieben sind.

### Kurze Beschreibung der Zeichnungen

Nachfolgend werden Ausführungsformen der Erfindung unter Bezugnahme auf die beigefügten Zeichnungen beschrieben, wobei weder die Zeichnungen noch die Beschreibung als die Erfindung einschränkend auszulegen sind.
Fig. 1 zeigt eine Darstellung eines Leiterplattensandwichs erhältlich mit einem Verfahren gemäß einem Ausführungsbeispiel der Erfindung;
Fig. 2 zeigt eine Darstellung zweier getrennter Leiterplattenteilbereiche für ein Leiterplattensandwich erhältlich mit einem Verfahren gemäß einem Ausführungsbeispiel der Erfindung;
Fig. 3 zeigt eine Darstellung zweier über einen Biegebereich verbundener Leiterplattenteilbereiche für ein Leiterplattensandwich erhältlich mit einem Verfahren gemäß einem Ausführungsbeispiel der Erfindung;
Fig. 4 zeigt eine Darstellung eines zusammengeklappten Leiterplattensandwichs erhältlich mit einem Verfahren gemäß einem Ausführungsbeispiel der Erfindung; und
Fig. 5 zeigt eine Darstellung eines Leiterplattenteilbereichs für nicht beanspruchtes Leiterplattensandwich.

Die Figuren sind lediglich schematisch und nicht maßstabsgetreu. Gleiche Bezugszeichen bezeichnen in den Figuren gleiche oder gleichwirkende Merkmale.

### Ausführungsformen der Erfindung

Verguss findet seit längerer Zeit Anwendung, um elektronische Komponenten vor Getriebeöl zu schützen. Hierbei wird ein pastöser sogenannter "DAM" Verguss als Umrandung aufgebracht. In die Umrandung wird ein flüssiger FILL-Verguss appliziert, der die Bauteile komplett abdeckt. Der noch flüssige Verguss wird in einem Ofenprozess ausgehärtet.

Die Anforderungen hinsichtlich kleinem Bauraum und hohen Packungsdichten steigen ständig. Der bisherige Fertigungsprozess erlaubt das Platzieren von Bauelementen nur in einer Ebene, wodurch in vielen Anwendungen eine große Fläche benötigt wird, um alle Komponenten unterzubringen. Oft steht der Bauraum im Getriebe nicht zur Verfügung.

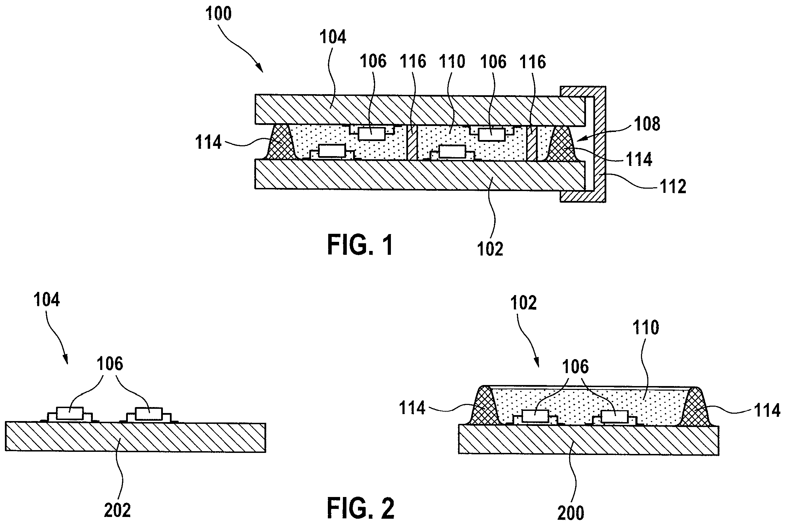

Fig. 1 zeigt eine Darstellung eines Leiterplattensandwichs 100. Hier werden die Komponenten auf eine zweigeteilte PCB bestückt. Das Leiterplattensandwich 100 weist einen ersten Leiterplattenteilbereich 102 und einen zweiten Leiterplattenteilbereich 104 auf. Die Leiterplattenteilbereiche 102, 104 sind zu einem Stapel übereinandergestapelt. Die Leiterplattenteilbereiche 102, 104 sind jeweils einseitig mit Bauteilen 106 bestückt. Die bestückten Seiten sind einander gegenüberliegend angeordnet. Die Bauteile 106 des ersten Leiterplattenteilbereichs 102 und des zweiten Leiterplattenteilbereichs sind auf Lücke angeordnet. Dabei sind die Bauteile 106 des ersten Leiterplattenteilbereichs 102 zwischen den Bauteilen 106 des zweiten Leiterplattenteilbereichs 104 angeordnet und umgekehrt. Ein Zwischenraum 108 zwischen den Leiterplattenteilbereichen 102, 104 und den Bauteilen 106 ist mit einer Vergussmasse 110 aufgefüllt. Die Vergussmasse 110 ist ausgehärtet und versiegelt den Zwischenraum 108 fluiddicht und dauerhaft.

Die Vergussmasse 110 wird in fließfähigem Zustand verarbeitet und erst dann ausgehärtet. Das Aushärten erfolgt beispielsweise in einem Ofen bei erhöhter Temperatur. Während des Aushärtens kann ein Abstand zwischen den Leiterplattenteilbereichen 102, 104 mittels temporärer Klammern 112 vorgegeben werden. Die Klammern 112 Umgreifen dabei die Leiterplattenteilbereiche 102, 104.

In einem Ausführungsbeispiel ist die Vergussmasse 110 von einem Dammbereich 114 umgeben. Der Dammbereich 114 verhindert ein Auslaufen der Vergussmasse 110 vor dem endgültigen Aushärten.

In einem nicht beanspruchten Beispiel sind beim Bestücken eines der Leiterplattenteilbereiche 102, 104 Abstandshalter 116 in dem Zwischenraum 108 angeordnet worden. Die Abstandshalter 116 halten die beiden Leiterplattenteilbereiche 102, 104 beim Stapeln und während des Aushärtens auf einem vorbestimmten Abstand.

Mit anderen Worten zeigt Fig. 1 eine bauraumoptimierte vergossene Elektronik für Getriebesteueranwendungen.

Fig. 2 zeigt eine Darstellung zweier getrennter Leiterplattenteilbereiche 102, 104 für ein Leiterplattensandwich. Die Leiterplattenteilbereiche 102, 104 sind auf separaten Leiterplatten 200, 202 gefertigt. Die Leiterplattenteilbereiche 102, 104 entsprechen dabei im Wesentlichen den Leiterplattenteilbereichen in Fig. 1. Hier sind die Leiterplattenteilbereiche 102, 104 vor dem Zusammenfügen zu dem Leiterplattensandwich dargestellt. Die Leiterplattenteilbereiche 102, 104 sind parallel nebeneinanderliegend von derselben Seite der Leiterplatten 200, 202 aus gefertigt. Dazu sind die Leiterplatten 200, 202 auf der Seite mit den Bauteilen 106 bestückt worden und beispielsweise durch Löten elektrisch mit Leiterbahnen in der jeweiligen Leiterplatte 200, 202 kontaktiert worden.

Es wird die Vergussmasse 110 im ersten Leiterplattenteilbereich 102 vergossen. Während die Vergussmasse 110 flüssig ist, wird der zweite Leiterplattenteilbereich 104 mit seinen Bauteilen 106 in die Vergussmasse eingetaucht, damit die Bauteile 106 des zweiten Leiterplattenteilbereichs 104 von der Vergussmasse 110 umschlossen werden. Bevor der zweite Leiterplattenteilbereich 102 beziehungsweise die zweite Leiterplatte 202 in die Vergussmasse 110 eingetaucht wird, wird die zweite Leiterplatte 202 gewendet.

In einem nicht beanspruchten Beispiel wird der erste Leiterplattenteilbereich 102 beziehungsweise die erste Leiterplatte 200 vor dem Vergießen in ein Werkzeug eingelegt. Das Werkzeug weist eine Vertiefung zum Begrenzen der Vergussmasse 110 auf. Das Werkzeug kann auch Stapelhilfen zum Ausrichten der zweiten Leiterplatte 202 aufweisen. Beispielsweise kann das Werkzeug Dorne zum Einstellen einer Relativposition der zweiten Leiterplatte 202 zu der ersten Leiterplatte 200 aufweisen. Die Dorne greifen in Aussparungen der zweiten Leiterplatte 202 ein. Die Dorne können auch als Stufendorne ausgeführt sein. Stufendorne weisen eine Auflagefläche zum Einstellen eines Abstands zwischen den Leiterplatten 200, 202 auf. Nach dem Aushärten wird das Leiterplattensandwich aus dem Werkzeug entnommen.

In einem Ausführungsbeispiel wird vor dem Vergießen der Dammbereich 114 um die Bauteile 106 des ersten Leiterplattenteilbereichs 102 herum aufgebracht, um eine Vertiefung zum eingießen der Vergussmasse 110 zu schaffen.

Wenn die Bauteile 106 des zweiten Leiterplattenteilbereichs 104 in die Vergussmasse 110 eintauchen, wird Vergussmasse 110 verdrängt. Überschüssige Vergussmasse 110 kann seitlich aus dem Zwischenraum zwischen den Leiterplatten 200, 202 gepresst werden.

Alternativ kann die Vertiefung unvollständig gefüllt werden. Durch die eintauchenden Bauelemente 106 steigt ein Spiegel der Vergussmasse 110 dann an, bis auch die zweite Leiterplatte 202 benetzt wird.

In einem Ausführungsbeispiel werden vor dem Vergießen im ersten Leiterplattenteilbereich 102 und/oder im zweiten Leiterplattenteilbereich 104 Stapelhilfen angeordnet. Beispielsweise werden Auflageelemente zum Einstellen eines Abstands zwischen den beiden Leiterplatten 200, 202 und/oder Anlageelemente zum Einstellen einer Relativposition der beiden Leiterplatten 200, 202 zueinander aufgebracht. Beim Eintauchen wird die zweite Leiterplatte 202 beziehungsweise der zweite Leiterplattenteilbereich 104 so weit in die Vergussmasse 110 gedrückt, bis die Auflageelemente aufliegen und/oder die Anlageelemente anlegen.

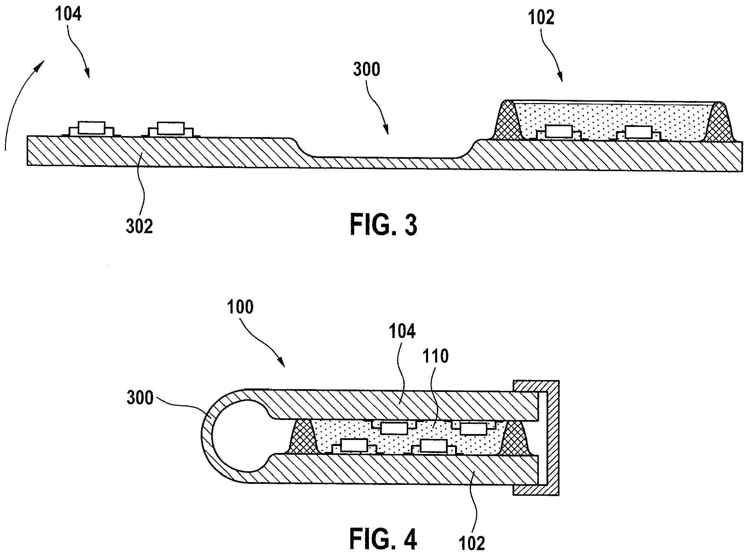

Fig. 3 zeigt eine Darstellung zweier über einen Biegebereich 300 verbundener Leiterplattenteilbereiche 102, 104 für ein Leiterplattensandwich. Die Leiterplattenteilbereiche 102, 104 entsprechen im Wesentlichen der Darstellung in Fig. 1. Im Gegensatz dazu sind die Leiterplattenteilbereiche 102, 104 Teil einer durchgehenden Leiterplatte 302. Die Leiterplatte 302 ist für den Biegebereich 300 zwischen den Leiterplattenteilbereichen 102, 104 ausgedünnt, beispielsweise durch eine Fräsung. Im Biegebereich 300 können Leiterbahnen verlaufen, die die Leiterplattenteilbereiche 102, 104 elektrisch miteinander verbinden.

Die PCB hat in der Mitte eine Ausfräsung die so dünn gestaltet ist, dass ein Umbiegen um 180° möglich ist. Der Verguss wird einseitig aufgebracht. Dann wird die andere PCB-Hälfte um 180° gebogen sodass die Bauelemente in den Verguss eintauchen.

Fig. 4 zeigt eine Darstellung eines zusammengeklappten Leiterplattensandwichs 100. Das Leiterplattensandwich 100 entspricht dabei im Wesentlichen dem Leiterplattensandwich in Fig. 1. Zusätzlich dazu ist hier ein um 180° gebogener Biegebereich 300, wie in Fig. 3 zwischen dem ersten Leiterplattenteilbereich 102 und dem zweiten Leiterplattenteilbereich 104 angeordnet. Im Bereich des Biegebereichs 300 ist keine Vergussmasse 110 angeordnet.

Schnapphaken an der Seite verhindern ein Aufbiegen der PCB. In diesem Zustand kommt die PCB in den Härteofen und es entsteht so eine zweilagiges Package in einer sehr kompakten Bauform.

Durch den hier vorgestellten Ansatz werden kein zusätzlicher Ofenprozess und keine längere Zykluszeit benötigt. Es ist eine sehr hohe Packungsdichte erreichbar. Es wird weniger teureres Vergussmaterial verbraucht, als beim separaten Verguss beider Seiten.

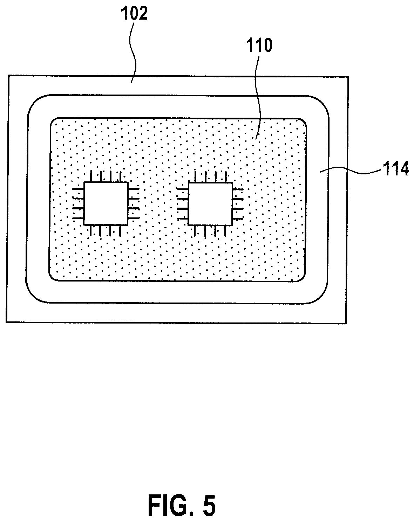

Fig. 5 zeigt eine Darstellung eines Leiterplattenteilbereichs 102 für ein Leiterplattensandwich Der Leiterplattenteilbereich 102 entspricht im Wesentlichen dem ersten Leiterplattenteilbereich in Fig. 2. Die Bauteile 106 sind hier integrierte Schaltungen. Um die Bauteile 106 herum, entlang einer Kante des Leiterplattenteilbereichs 102 verläuft der Dammbereich 114, um Die Vergussmasse 110 am Auslaufen zu hindern.

Abschließend ist darauf hinzuweisen, dass Begriffe wie "aufweisend", "umfassend", etc. keine anderen Elemente oder Schritte ausschließen und Begriffe wie "eine" oder "ein" keine Vielzahl ausschließen. Bezugszeichen in den Ansprüchen sind nicht als Einschränkung anzusehen.

## Patentansprüche

1. Verfahren zum Herstellen eines Leiterplattensandwichs (100), **dadurch gekennzeichnet, dass** das Verfahren die in der nachfolgend angegebenen Reihenfolge ausgeführten Schritte aufweist:
Fertigen eines ersten Leiterplattenteilbereichs (102) und eines zweiten Leiterplattenteilbereichs (104), wobei der erste Leiterplattenteilbereich (102) und der zweite Leiterplattenteilbereich (104) je einseitig mit Bauteilen (106) versehen werden;
Vergießen der Bauteile (106) in dem ersten Leiterplattenteilbereich (102) mit einer Vergussmasse (110);
Wenden des zweiten Leiterplattenteilbereichs (104), sodass die Bauteile (106) in dem zweiten Leiterplattenteilbereich (104) den Bauteilen (106) im ersten Leiterplattenteilbereich (102) gegenüberliegend angeordnet sind;
Stapeln des zweiten Leiterplattenteilbereichs (104) auf den ersten Leiterplattenteilbereich (102), sodass die Bauteile (106) im zweiten Leiterplattenteilbereich (104) in die Vergussmasse (110) eintauchen; und
Aushärten der Vergussmasse (110), um den ersten Leiterplattenteilbereich (102) und den zweiten Leiterplattenteilbereich (104) zu dem Leiterplattensandwich (100) zu verbinden.

2. Verfahren gemäß Anspruch 1, bei dem im Schritt des Stapelns die Bauteile (106) im zweiten Leiterplattenteilbereich (104) so weit in die Vergussmasse (110) eingetaucht werden, bis die Vergussmasse (110) den zweiten Leiterplattenteilbereich (104) benetzt.

3. Verfahren gemäß einem der vorhergehenden Ansprüche, bei dem im Schritt des Stapelns der erste Leiterplattenteilbereich (102) und der zweite Leiterplattenteilbereich (104) unter Verwendung zumindest einer Stapelhilfe zueinander ausgerichtet werden.

4. Verfahren gemäß Anspruch 3, bei dem im Schritt des Fertigens die zumindest eine Stapelhilfe im ersten Leiterplattenteilbereich (102) und/oder im zweiten Leiterplattenteilbereich (104) angeordnet wird.

5. Verfahren gemäß einem der Ansprüche 3 bis 4, bei dem im Schritt des Fertigens der erste Leiterplattenteilbereich (102) mit einem ersten Teil eines elektrischen Kontaktelements gefertigt wird und der zweite Leiterplattenteilbereich (104) mit einem zweiten Teil des Kontaktelements gefertigt wird, wobei im Schritt des Stapelns der erste Teil und der zweite Teil elektrisch leitend miteinander verbunden werden, wobei der erste Leiterplattenteilbereich (102) und der zweite Leiterplattenteilbereich (104) unter Verwendung des ersten Teils und des zweiten Teils zueinander ausgerichtet werden.

6. Verfahren gemäß einem der vorhergehenden Ansprüche, bei dem im Schritt des Fertigens die Bauteile (106) im ersten Leiterplattenteilbereich (102) so angeordnet werden, dass sie im Schritt des Stapelns auf Lücke zu den Bauteilen (106) im zweiten Leiterplattenteilbereich (104) angeordnet sind und/oder Im Schritt des Fertigens die Bauteile (106) im zweiten Leiterplattenteilbereich (104) so angeordnet werden, dass sie im Schritt des Stapelns auf Lücke zu den Bauteilen im ersten Leiterplattenteilbereich (102) angeordnet sind.

7. Verfahren gemäß einem der vorhergehenden Ansprüche, bei dem im Schritt des Fertigens die Bauteile (106) im ersten Leiterplattenteilbereich (102) und die Bauteile (106) im zweiten Leiterplattenteilbereich (104) auf einer durchgehenden Leiterplatte (302) angeordnet werden, wobei zwischen dem ersten Leiterplattenteilbereich (102) und dem zweiten Leiterplattenteilbereich (104) ein Biegebereich (300) angeordnet ist, der im Schritt des Wendens gebogen wird.

8. Verfahren gemäß einem der vorhergehenden Ansprüche, bei dem im Schritt des Vergießens um den ersten Leiterplattenteilbereich (102) mit einem Dammmaterial ein umlaufender Dammbereich (114) aufgebaut wird und ein Raum innerhalb des Dammbereichs (114) mit der Vergussmasse (110) zumindest teilweise aufgefüllt wird.

## Claims

1. Method for producing a printed circuit board sandwich (100), **characterized in that** the method comprises the steps which are executed in the order specified below:
manufacturing a first printed circuit board subregion (102) and a second printed circuit board subregion (104), wherein the first printed circuit board subregion (102) and the second printed circuit board subregion (104) are each provided with components (106) on one side;
potting the components (106) in the first printed circuit board subregion (102) using a potting compound (110);
turning the second printed circuit board subregion (104), so that the components (106) in the second printed circuit board subregion (104) are arranged opposite the components (106) in the first printed circuit board subregion (102);
stacking the second printed circuit board subregion (104) onto the first printed circuit board subregion (102), so that the components (106) in the second printed circuit board subregion (104) are immersed in the potting compound (110); and
curing the potting compound (110) in order to connect the first printed circuit board subregion (102) and the second printed circuit board subregion (104) to form the printed circuit board sandwich (100).

2. Method according to Claim 1, in which, in the stacking step, the components (106) in the second printed circuit board subregion (104) are immersed in the potting compound (110) until the potting compound (110) wets the second printed circuit board subregion (104).

3. Method according to either of the preceding claims, in which, in the stacking step, the first printed circuit board subregion (102) and the second printed circuit board subregion (104) are aligned with one using at least one stacking aid.

4. Method according to Claim 3, in which, in the manufacturing step, the at least one stacking aid is arranged in the first printed circuit board subregion (102) and/or in the second printed circuit board subregion (104).

5. Method according to either of Claims 3 and 4, in which, in the manufacturing step, the first printed circuit board subregion (102) is manufactured with a first part of an electrical contact element and the second printed circuit board subregion (104) is manufactured with a second part of the contact element, wherein, in the stacking step, the first part and the second part are electrically conductively connected to one another, wherein the first printed circuit board subregion (102) and the second printed circuit board subregion (104) are aligned with one another using the first part and the second part.

6. Method according to one of the preceding claims, in which, in the manufacturing step, the components (106) in the first printed circuit board subregion (102) are arranged such that, in the stacking step, they are arranged in gaps with respect to the components (106) in the second printed circuit board subregion (104) and/or, in the manufacturing step, the components (106) in the second printed circuit board subregion (104) are arranged such that, in the stacking step, they are arranged in gaps with respect to the components in the first printed circuit board subregion (102).

7. Method according to one of the preceding claims, in which, in the manufacturing step, the components (106) in the first printed circuit board subregion (102) and the components (106) in the second printed circuit board subregion (104) are arranged on a continuous printed circuit board (302), wherein a bent region (300), which is bent in the turning step, is arranged between the first printed circuit board subregion (102) and the second printed circuit board subregion (104).

8. Method according to one of the preceding claims, in which, in the potting step, an encircling insulation region (114) is constructed around the first printed circuit board subregion (102) by an insulating material and a space within the insulation region (114) is at least partially filled with the potting compound (110).

## Revendications

1. Procédé de fabrication d'un sandwich de cartes de circuits imprimés (100), **caractérisé en ce que** le procédé présente les étapes exécutées dans l'ordre indiqué ci-après :
la fabrication d'une première portion de carte de circuits imprimés (102) et d'une deuxième portion de carte de circuits imprimés (104), la première portion de carte de circuits imprimés (102) et la deuxième portion de carte de circuits imprimés (104) étant équipées de composants (106) sur une face ;
l'enrobage des composants (106) dans la première portion de carte de circuits imprimés (102) avec un composé d'enrobage (110) ;
le retournement de la deuxième portion de carte de circuits imprimés (104) de sorte que les composants (106) dans la deuxième portion de carte de circuits imprimés (104) sont disposés à l'opposé des composants (106) dans la première portion de carte de circuits imprimés (102) ;
l'empilement de la deuxième portion de carte de circuits imprimés (104) sur la première portion de carte de circuits imprimés (102) de sorte que les composants (106) dans la deuxième portion de carte de circuits imprimés (104) pénètrent dans le composé d'enrobage (110) ; et
le durcissement du composé d'enrobage (110) pour relier la première portion de carte de circuits imprimés (102) et la deuxième portion de carte de circuits imprimés (104) afin de former le sandwich de cartes de circuits imprimés (100).

2. Procédé selon la revendication 1, dans lequel à l'étape d'empilement, les composants (106) dans la deuxième portion de carte de circuits imprimés (104) sont plongés dans le composé d'enrobage (110) jusqu'à ce que le composé d'enrobage (110) humecte la deuxième portion de carte de circuits imprimés (104).

3. Procédé selon l'une quelconque des revendications précédentes, dans lequel à l'étape d'empilement, la première portion de carte de circuits imprimés (102) et la deuxième portion de carte de circuits imprimés (104) sont alignées l'une par rapport à l'autre en utilisant au moins un accessoire d'empilement.

4. Procédé selon la revendication 3, dans lequel à l'étape de fabrication, ledit au moins un accessoire d'empilement est disposé dans la première portion de carte de circuits imprimés (102) et/ou dans la deuxième portion de carte de circuits imprimés (104).

5. Procédé selon l'une quelconque des revendications 3 et 4, dans lequel à l'étape de fabrication, la première portion de carte de circuits imprimés (102) est fabriquée avec une première partie d'un élément de contact électrique, et la deuxième portion de carte de circuits imprimés (104) est fabriquée avec une deuxième partie de l'élément de contact, dans lequel à l'étape d'empilement, la première partie et la deuxième partie sont reliées ensemble de manière électriquement conductrice, la première portion de carte de circuits imprimés (102) et la deuxième portion de carte de circuits imprimés (104) étant alignées l'une par rapport à l'autre en utilisant la première partie et la deuxième partie.

6. Procédé selon l'une quelconque des revendications précédentes, dans lequel à l'étape de fabrication, les composants (106) dans la première portion de carte de circuits imprimés (102) sont disposés de telle sorte qu'à l'étape d'empilement, ils sont disposés en quinconce par rapport aux composants (106) dans la deuxième portion de carte de circuits imprimés (104), et/ou à l'étape de fabrication, les composants (106) dans la deuxième portion de carte de circuits imprimés (104) sont disposés de telle sorte qu'à l'étape d'empilement, ils sont disposés en quinconce par rapport aux composants dans la première portion de carte de circuits imprimés (102).

7. Procédé selon l'une quelconque des revendications précédentes, dans lequel à l'étape de fabrication, les composants (106) dans la première portion de carte de circuits imprimés (102) et les composants (106) dans la deuxième portion de carte de circuits imprimés (104) sont disposés sur une carte de circuits imprimés continue (302), dans lequel une zone de courbure (300), qui est courbée à l'étape de retournement, est disposée entre la première portion de carte de circuits imprimés (102) et la deuxième portion de carte de circuits imprimés (104).

8. Procédé selon l'une quelconque des revendications précédentes, dans lequel à l'étape d'enrobage, une zone de barrage périphérique (114) est créée avec un matériau de barrage autour de la première portion de carte de circuits imprimés (102), et un espace à l'intérieur de la zone de barrage (114) est comblé au moins partiellement avec le composé d'enrobage (110).
